# EUROPÄISCHE PATENTANMELDUNG

(11) **EP 3 499 553 A1**
(43) Veröffentlichungstag der Anmeldung: **19.06.2019**
(21) Anmeldenummer: 17207043.5
(22) Anmeldetag: 13.12.2017
(51) Int. Cl.: H01L 21/60, H05K 3/34

(54) **VERFAHREN ZUR HERSTELLUNG EINES MIT EINER LOTVORFORM VERBUNDENEN BAUELEMENTS MITTELS HEISSPRESSENS UNTERHALB DER SCHMELZTEMPERATUR DES LOTMATERIALS**

(71) Anmelder: Heraeus Deutschland GmbH & Co. KG, 63450 Hanau (DE)
(72) Erfinder: SCHÄFER, Michael, 36093 Künzell (DE); SCHMITT, Wolfgang, 63110 Rodgau (DE); PELSHAW, Nadja, 63517 Rodenbach (DE)
(74) Vertreter: Heraeus IP

(57) **Zusammenfassung**

Verfahren zur Herstellung eines mit einer Lotvorform verbundenen Bauelements umfasst die Schritte:
(1) Bereitstellen eines mindestens eine Kontaktfläche aufweisenden Bauelements und einer freien Lotvorform,
(2) Herstellen einer Anordnung aus dem Bauelement und der damit noch nicht verbundenen Lotvorform durch Inkontaktbringen einer oder der einzigen Kontaktfläche des Bauelements mit einer Kontaktfläche der freien Lotvorform, und
(3) Heißpressen der in Schritt (2) hergestellten Anordnung unter Bildung des mit der Lotvorform verbundenen Bauelementes bei einer 10 bis 40% unterhalb der in °C ausgedrückten Schmelztemperatur des Lotmetalls der Lotvorform liegenden Temperatur und einer dabei eine Reduktion der ursprünglichen Dicke der ursprünglich freien Lotvorform von ≤10% bewirkenden Kombination von Pressdruck und Pressdauer.

Das Bauelement kann ein Substrat, ein aktives Bauelement oder ein passives Bauelement sein.

Das Verfahren kann die weiteren Schritte umfassen:
(4) Herstellen einer Sandwichanordnung aus mit dem Bauelement verbundener Lotvorform und einem damit zu verbindenden weiteren Bauelement durch Inkontaktbringen der nach außen weisenden Lotmetall-Kontaktfläche der mit dem Bauelement verbundenen Lotvorform mit einer oder der einzigen Kontaktfläche des weiteren Bauelements,
(5) Erhitzen der Sandwichanordnung auf eine Temperatur oberhalb der Schmelztemperatur des Lotmetalls der Lotvorform, und
(6) Abkühlen der Sandwichanordnung unter die Erstarrungstemperatur des zwischen den Bauelementen befindlichen geschmolzenen Lotmetalls unter Ausbildung einer Lötverbindung zwischen den Bauelementen.

Alternativ kann das Verfahren anstatt der Schritte (4)-(6) die weiteren Schritte umfassen:
(4') Herstellen einer Sandwichanordnung aus mit dem Bauelement verbundener Lotvorform und einem damit zu verbindenden weiteren Bauelement durch Inkontaktbringen der nach außen weisenden Lotmetall-Kontaktfläche der mit dem Bauelement verbundenen Lotvorform mit einer oder der einzigen Kontaktfläche des weiteren Bauelements, und
(5') Heißpressen der in Schritt (4') hergestellten Sandwichanordnung bei einer 10 bis 40% unterhalb der in °C ausgedrückten Schmelztemperatur des Lotmetalls der mit dem in Schritt (1) bereitgestellten Bauelement verbundenen Lotvorform liegenden Temperatur unter Ausbildung einer Lotverbindung zwischen den Bauelementen, wobei die während Schritt (5') wirkende Kombination von Pressdruck und Pressdauer in einem Bereich liegt, welcher eine Reduktion der Dicke der verbundenen Lotvorform von <10% bewirken kann.

## Beschreibung

Die Erfindung betrifft ein Verfahren zur Herstellung eines mit einer Lotvorform verbundenen Bauelements.

Der hierin verwendete Ausdruck "mit einer Lotvorform verbundenes Bauelement" bedeutet, dass Lotvorform und Bauelement mit einer Scherfestigkeit von >0,1 MPa aneinander haften; anders ausgedrückt, sie weisen eine die Haftfestigkeit aneinander beschreibende Scherfestigkeit von >0,1 MPa auf. Die Scherfestigkeit kann mittels eines üblichen Schertesters bestimmt werden.

US 4,659,006 offenbart das Verbinden eines Substrats mit einer freien Lotvorform durch Heißpressen als Teilschritt eines Verfahrens zur Herstellung einer Lötverbindung zwischen einem Halbleiterchip und einem Substrat. Beim Verbinden des Substrats mit der freien Lotvorform werden Substrat und Lotvorform zunächst miteinander in Kontakt gebracht und anschließend gemeinsam auf eine unterhalb der Schmelztemperatur der Lotvorform liegende Temperatur erhitzt. Während der Einwirkung dieser Temperatur wird ein Pressdruck auf die Lotvorform ausgeübt. Dabei wird die ursprüngliche Dicke der Lotvorform um mindestens 40% reduziert. Anschließend wird die so geschaffene Anordnung aus mit Lotdepot ausgestattetem Substrat mit einem Halbleiterchip in üblicher Weise verlötet.

Hierin wird bewusst zwischen einer Lot- und einer Lötverbindung von Bauelementen unterschieden. Während Lotverbindung wie auch Lötverbindung beide eine thermisch leitende, elektrisch leitende und mechanische Verbindung von Bauelementen bewirken, besteht der Unterschied zwischen Lotverbindung und Lötverbindung darin, dass das Lotmetall bei der Bildung einer Lötverbindung anders als bei der Bildung einer Lotverbindung zwischen den Bauelementen geschmolzen und wieder erstarrt wird, mit anderen Worten, über seine Schmelztemperatur hinaus erhitzt und danach unter seine Erstarrungstemperatur abgekühlt wird.

Die Anmelderin konnte nunmehr für sie selber überraschend feststellen, dass das Verbinden eines Bauelements mit einer freien Lotvorform gelingt, wenn im Wesentlichen ähnlich der aus US 4,659,006 bekannten Vorgehensweise, jedoch unter milderen Heißpressbedingungen gearbeitet wird.

Die Erfindung betrifft ein Verfahren zur Herstellung eines mit einer Lotvorform verbundenen Bauelements. Das Verfahren umfasst die Schritte:
(1) Bereitstellen eines mindestens eine Kontaktfläche aufweisenden Bauelements und einer freien Lotvorform,
(2) Herstellen einer Anordnung aus dem Bauelement und der damit noch nicht verbundenen Lotvorform durch Inkontaktbringen einer oder der einzigen Kontaktfläche des Bauelements mit einer Kontaktfläche der freien Lotvorform, und
(3) Heißpressen der in Schritt (2) hergestellten Anordnung unter Bildung des mit der Lotvorform verbundenen Bauelements bei einer 10 bis 40% unterhalb der in °C ausgedrückten Schmelztemperatur des Lotmetalls der Lotvorform liegenden Temperatur und einer dabei eine Reduktion der ursprünglichen Dicke der ursprünglich freien Lotvorform von ≤10% bewirkenden Kombination von Pressdruck und Pressdauer.

In Schritt (1) des Verfahrens wird ein eine einzige oder mehrere Kontaktflächen aufweisendes Bauelement bereitgestellt.

Im Rahmen der Erfindung soll der Begriff Bauelement vorzugsweise Einzelteile umfassen. Diese Einzelteile sind vorzugsweise nicht weiter zerlegbar.

Die Kontaktfläche(n) von Bauelementen sind im Allgemeinen metallisch, beispielsweise in Form einer Metallisierungsschicht. Das Metall eines Bauelements respektive seiner Kontaktfläche(n) kann reines Metall oder eine Legierung aus >50 bis <100 Gew.-% des Metalls und dementsprechend >0 bis <50 Gew.-% aus mindestens einem anderen Metall sein. Beispiele für das reine Metall respektive das Legierungshauptmetall sind Zinn, Kupfer, Silber, Gold, Nickel, Palladium und Platin, insbesondere Zinn, Kupfer, Silber, Gold, Palladium und Platin.

Die in Schritt (2) bei der Herstellung der Anordnung genutzte Kontaktfläche des Bauelements kann eine Größe beispielsweise im Bereich von 1 bis 3000 mm², insbesondere >10 bis 1000 mm², speziell 15 bis 500 mm² haben.

Bei einem Bauelement im Sinne der Erfindung kann es sich um ein Substrat oder um ein aktives oder ein passives Bauelement handeln. Insbesondere handelt es sich um ein Bauteil wie es in der Elektronik verwendet wird.

Beispiele für Substrate sind IMS-Substrate (insulated metal-Substrate), DCB-Substrate (direct copper bonded-Substrate), AMB-Substrate (active metal braze-Substrate), keramische Substrate, PCBs (printed circuit boards) und Leadframes.

Beispiele für aktive Bauelemente sind Dioden, LEDs (light emitting diodes, lichtemittierende Dioden), Dies (Halbleiterchips), IGBTs (insulated-gate bipolar transistors, Bipolartransistoren mit isolierter Gate-Elektrode), ICs (integrated circuits, integrierte Schaltungen) und MOSFETs (metal-oxide-semiconductor field-effect transistors, Metall-Oxid-Halbleiter-Feldeffekttransistoren).

Beispiele für passive Bauelemente sind Sensoren, Bodenplatten, Kühlkörper, Widerstände, Kondensatoren, Transformatoren, Drosseln und Spulen.

Außer dem mindestens eine Kontaktfläche aufweisenden Bauelement wird in Schritt (1) des Verfahrens eine freie, d.h. diskrete Lotvorform bereitgestellt.

Bei einer freien Lotvorform im Sinne der Erfindung handelt es sich insbesondere um Lotmetall in Form eines flachen Formteils, beispielsweise Lotmetallfolie, Lotmetallband oder ein Lotmetallplättchen. Solche freien Lotvorformen haben diskrete Kontaktflächen, d.h. voneinander separate und unterscheidbare Kontaktflächen, insbesondere zwei auf einander gegenüberliegenden Seiten angeordnete Kontaktflächen. Die Form der Kontaktflächen kann beliebig sein, beispielsweise rund, sechseckig, dreieckig, bevorzugt rechteckig. Größe und Form entsprechen bevorzugt der der Kontaktfläche des Bauelements. Die Dicke der freien Lotvorform kann beispielsweise im Bereich von 10 bis 500 µm oder 50 bis 300 µm liegen.

Bei dem Lotmetall (Lot) der Lotvorform handelt es sich im Allgemeinen um Indium, Indiumlegierungen oder insbesondere um Zinn oder zinnreiche Legierungen. Beispiele für zinnreiche Legierungen sind solche mit einem Zinnanteil beispielsweise im Bereich von 90 bis 99,5 Gew.-% (Gewichts-%). Beispiele für Legierungsmetalle sind Kupfer, Silber, Indium, Germanium, Nickel, Blei, Bismut und Antimon. Die Legierungen können bleihaltig oder bleifrei sein. Bleifreie Legierungen können beispielsweise ausgewählt sein aus der Gruppe bestehend aus SnAg, SnBi, SnSb, SnAgCu, SnCu, SnSb, InSnCd, InBiSn, InSn, BiSnAg oder SnAgCuBiSbNi. Bleihaltige Legierungen können beispielsweise ausgewählt sein aus der Gruppe umfassend SnPb und SnPbAg. Die Schmelztemperatur des Lotmetalls kann beispielsweise im Bereich von 140 bis 380°C, insbesondere 170 bis 300°C liegen.

In Schritt (2) des erfindungsgemäßen Verfahrens wird eine aus dem Bauelement und der Lotvorform bestehende Anordnung hergestellt, bei der Bauelement und Lotvorform noch nicht miteinander verbunden sind. Die Lotvorform ist dabei zwar lediglich angeordnet, aber nicht mehr so wie ursprünglich frei. Zu dem Zweck wird eine Kontaktfläche der freien Lotvorform mit einer oder der einzigen Kontaktfläche des Bauelements in Kontakt gebracht, beispielsweise durch Platzieren der freien Lotvorform mit einer ihrer Kontaktflächen zur betreffenden Kontaktfläche des Bauelements hingewandt. Im Allgemeinen bedeutet Platzieren der freien Lotvorform ein Auflegen derselben auf das Bauelement oder umgekehrt, respektive ein Bestücken des Bauelements mit der freien Lotvorform oder umgekehrt.

In einer Ausführungsform kann ein Fixiermittel aus einer Fixiermittelzusammensetzung zwischen den beiden miteinander in Kontakt zu bringenden Kontaktflächen verwendet werden respektive auf eine oder beide Kontaktflächen vor dem miteinander Inkontaktbringen appliziert werden.

In Schritt (3) des erfindungsgemäßen Verfahrens wird die in Schritt (2) hergestellte Anordnung einer Heißpressung unterworfen, bei der sich Bauelement und angeordnete Lotvorform zu einem mit einer Lotvorform verbundenen Bauelement verbinden. Das mit der Lotvorform verbundene Bauelement weist eine nach außen weisende Lotmetall-Kontaktfläche auf. Bei der verbundenen Lotvorform handelt es sich um ein sogenanntes Lotdepot.

Als Arbeitsgerät kann beispielsweise eine übliche Heißpresse verwendet werden. Das Heißpressen findet statt bei einer 10 bis 40% unterhalb der in °C ausgedrückten Schmelztemperatur des Lotmetalls der Lotvorform liegenden Temperatur und unter Einwirkung einer dabei eine Reduktion der ursprünglichen Dicke der ursprünglich freien Lotvorform (d.h. der Lotvorform in ihrem ursprünglichen freien Zustand) von ≤10% bewirkenden Kombination von Pressdruck und Pressdauer. Beispielsweise kann die Schmelztemperatur des Lotmetalls konkret im Bereich von 140 bis 380 °C liegen und die Temperatur dann während des Heißpressens beispielsweise im Bereich von 84 bis 342 °C. Abhängig von der ursprünglichen Dicke der ursprünglich freien Lotvorform kann besagte bei ≤10% liegende Dickenreduktion beispielsweise im Bereich von 0 bis 50 µm liegen.

Die Kombination von Pressdruck und Pressdauer, welche bei einer 10 bis 40% unterhalb der in °C ausgedrückten Schmelztemperatur des Lotmetalls der Lotvorform liegenden Temperatur eine Reduktion der ursprünglichen Dicke der ursprünglich freien Lotvorform von ≤10% bewirkt, kann beispielsweise im Bereich von 10 bis 200 MPa Pressdruck und 1 Sekunde bis 5 Minuten Pressdauer liegen. Je höher der gewählte Pressdruck, desto kürzer kann die Pressdauer gewählt werden und umgekehrt.

Das erfindungsgemäße Verfahren arbeitet mit bedeutend milderen als den in eingangs erwähnter US 4,659,006 offenbarten Heißpressbedingungen. Es erzielt dabei eine hinreichend feste Verbindung von Bauelement mit ursprünglich freier Lotvorform.

Wie vorerwähnt hat das erfindungsgemäße Verfahren diverse Vorteile, sowohl mit Blick auf die eigentliche Verfahrensdurchführung als auch hinsichtlich des direkten Verfahrensprodukts in Form des mit der ursprünglich freien Lotvorform verbundenen Bauelements.

Das erfindungsgemäße Verfahren kann mit einer vergleichsweise einfach gebauten Heißpresse durchgeführt werden.

Das erfindungsgemäße Verfahren kann auch mit druckempfindlicheren als den in eingangs erwähnter US 4,659,006 offenbarten Bauelementen durchgeführt werden.

In Ausführungsformen kann das erfindungsgemäße Verfahren respektive das Heißpressen sogar, ohne besondere Vorkehrungen zu treffen, in normaler Umgebungsatmosphäre, also an der Luft durchgeführt werden, d.h. es ist weder erforderlich unter Inertgas noch in reduzierender Atmosphäre wie beispielsweise einer Inertgas/Wasserstoff-Atmosphäre zu arbeiten.

Die mit dem Bauelement im erfindungsgemäßen Verfahren verbundene Lotvorform zeichnet sich nicht nur durch eine ≤10% gegenüber der ursprünglichen Dicke der ursprünglich freien Lotvorform verringerte Dicke aus, sondern auch durch nach Beendigung des Heißpressens im Wesentlichen gegenüber dem Ursprung unveränderte Form und Flächenmaß. So treten im Wesentlichen keine Ausbuchtungen an den Außenrändern der mit dem Bauelement im erfindungsgemäßen Verfahren verbundenen Lotvorform auf, eine vorteilhafte Tatsache im Hinblick auf eine fortschreitende Miniaturisierung im Elektronikbereich und der damit einhergehenden Erhöhung der Bauelementdichte. Beispielsweise bleiben ursprünglich rechteckige freie Lotvorformen auch in mit dem Bauelement verbundener Form im Wesentlichen rechteckig mit im Wesentlichen geraden, d.h. im Wesentlichen nicht gebogenen Außenrändern. Der in diesem Absatz mehrfach verwendete Ausdruck "im Wesentlichen" bezieht sich auf eine Betrachtung mit dem bloßen Auge.

Das im erfindungsgemäßen Verfahren hergestellte mit einer Lotvorform verbundene Bauelement kann verwendet werden, um ein weiteres Bauelement damit zu verbinden, oder, anders ausgedrückt, um eine feste Sandwichanordnung aus dem in Schritt (1) bereitgestellten ersten und einem weiteren Bauelement mit dazwischen befindlichem Lot zu schaffen. Zu diesem Zweck kann die nach außen weisende Lotmetall-Kontaktfläche des nach dem erfindungsgemäßen Verfahren hergestellten mit einer Lotvorform verbundenen Bauelements mit einer oder der einzigen Kontaktfläche des damit zu verbindenden weiteren Bauelements in Kontakt gebracht und nachfolgend verbunden werden.

Der hierin verwendete Ausdruck "feste Sandwichanordnung" bedeutet, dass die Bauelemente, über das dazwischen befindliche Lot vermittelt, mit einer Scherfestigkeit von >0,1 MPa aneinander haften; anders ausgedrückt, sie weisen eine die Haftfestigkeit aneinander beschreibende Scherfestigkeit von >0,1 MPa auf. Die Scherfestigkeit kann mittels eines üblichen Schertesters bestimmt werden.

Das in Schritt (1) bereitgestellte erste und das damit zu verbindende weitere Bauelement können von derselben Art sein, d.h. es kann sich beispielsweise in beiden Fällen um Substrate handeln, oder es handelt sich jeweils um aktive oder passive Bauelemente oder um ein aktives und ein passives Bauelement. Es kann aber auch sein, dass es sich bei dem einen Bauelement um ein Substrat und bei dem anderen Bauelement um ein aktives oder passives Bauelement handelt, oder umgekehrt. Beispielsweise lassen sich so folgende Fälle unterscheiden:

| **Erstes Bauelement:** | **Weiteres Bauelement:** |
|---|---|
| Substrat | Substrat |
| Aktives Bauelement | Passives Bauelement |
| Passives Bauelement | Aktives Bauelement |
| Aktives Bauelement | Aktives Bauelement |
| Passives Bauelement | Passives Bauelement |
| Substrat | Aktives Bauelement |
| Substrat | Passives Bauelement |
| Passives Bauelement | Substrat |
| Aktives Bauelement | Substrat |

Zur Herstellung der Verbindung zwischen den beiden Bauelementen bestehen zwei Möglichkeiten. Zum einen kann ein klassischer Lötvorgang durchgeführt werden, alternativ kann analog wie beim vorerwähnten Heißpressvorgang vorgegangen werden.

Bei der dem Fachmann an sich bekannten und daher keiner näheren Erläuterung bedürfenden Alternative des klassischen Lötens schließen sich ans erfindungsgemäße Verfahren folgende weitere Schritte an:
(4) Herstellen einer Sandwichanordnung aus mit dem Bauelement verbundener Lotvorform und einem damit zu verbindenden weiteren Bauelement durch Inkontaktbringen der nach außen weisenden Lotmetall-Kontaktfläche der mit dem Bauelement verbundenen Lotvorform mit einer oder der einzigen Kontaktfläche des weiteren Bauelements,
(5) Erhitzen der Sandwichanordnung auf eine Temperatur oberhalb der Schmelztemperatur des Lotmetalls der Lotvorform, und
(6) Abkühlen der Sandwichanordnung unter die Erstarrungstemperatur des zwischen den Bauelementen befindlichen geschmolzenen Lotmetalls unter Ausbildung einer Lötverbindung zwischen den Bauelementen.

In Schritt (4) wird die nach außen weisende Lotmetall-Kontaktfläche der in Schritt (3) mit dem Bauelement verbundenen Lotvorform mit einer oder der einzigen Kontaktfläche des weiteren Bauelements in Kontakt gebracht, beispielsweise durch Platzieren des weiteren Bauelements mit der betreffenden Kontaktfläche zur Lotmetall-Kontaktfläche hingewandt. Im Allgemeinen bedeutet Platzieren ein Auflegen des weiteren Bauelements auf die in Schritt (3) hergestellte Anordnung oder umgekehrt, respektive ein Bestücken der in Schritt (3) hergestellten Anordnung mit dem weiteren Bauelement oder umgekehrt.

Bei Schritt (5) handelt es sich um ein Verlöten.

Nach Abschluss von Schritt (6) erhält man eine feste Sandwichanordnung aus dem ursprünglich in Schritt (1) bereitgestellten Bauelement und dem in Schritt (4) bereitgestellten weiteren Bauelement mit dazwischen befindlichem die beiden Bauelemente thermisch leitend, elektrisch leitend und mechanisch verbindendem Lot.

Bei der anderen Alternative des Heißpressens schließen sich ans erfindungsgemäße Verfahren hingegen folgende weitere Schritte an:
(4') Herstellen einer Sandwichanordnung aus mit dem Bauelement verbundener Lotvorform und einem damit zu verbindenden weiteren Bauelement durch Inkontaktbringen der nach außen weisenden Lotmetall-Kontaktfläche der mit dem Bauelement verbundenen Lotvorform mit einer oder der einzigen Kontaktfläche des weiteren Bauelements, und
(5') Heißpressen der in Schritt (4') hergestellten Sandwichanordnung bei einer 10 bis 40% unterhalb der in °C ausgedrückten Schmelztemperatur des Lotmetalls der mit dem in Schritt (1) bereitgestellten Bauelement verbundenen Lotvorform liegenden Temperatur unter Ausbildung einer Lotverbindung zwischen den Bauelementen.

In Schritt (4') wird die nach außen weisende Lotmetall-Kontaktfläche der mit dem Bauelement verbundenen Lotvorform mit einer oder der einzigen Kontaktfläche des weiteren Bauelements in Kontakt gebracht, beispielsweise durch Platzieren des weiteren Bauelements mit der betreffenden Kontaktfläche zur Lotmetall-Kontaktfläche hingewandt. Im Allgemeinen bedeutet Platzieren ein Auflegen des weiteren Bauelements auf die in Schritt (3) hergestellte Anordnung oder umgekehrt, respektive ein Bestücken der in Schritt (3) hergestellten Anordnung mit dem weiteren Bauelement oder umgekehrt.

In Schritt (5') wird die in Schritt (4') hergestellte Sandwichanordnung einer Heißpressung unterworfen, bei der sich das mit der Lotvorform verbundene Bauelement und das weitere Bauelement verbinden. Dabei bildet sich eine Lotverbindung zwischen den Bauelementen aus.

Als Arbeitsgerät kann eine übliche Heißpresse verwendet werden. Das Heißpressen findet statt bei einer 10 bis 40% unterhalb der in °C ausgedrückten Schmelztemperatur des Lotmetalls der Lotvorform liegenden Temperatur bezüglich derer auf das Vorerwähnte verwiesen wird. Bevorzugt liegen Pressdruck und Pressdauer, d.h. die Kombination beider, dabei in einem Bereich, welcher eine Reduktion der Dicke der verbundenen Lotvorform (d.h. im Zustand nach Beendigung von Schritt (3)) von ≤10% bewirkt; beispielsweise können dann der Pressdruck im Bereich von 10 bis 200 MPa und die Pressdauer im Bereich von 1 Sekunde bis 5 Minuten liegen. Je höher der gewählte Pressdruck, desto kürzer kann die Pressdauer gewählt werden und umgekehrt.

In Ausführungsformen kann Schritt (5'), ohne besondere Vorkehrungen zu treffen, in normaler Umgebungsatmosphäre, also an der Luft durchgeführt werden, d.h. es ist weder erforderlich unter Inertgas noch in reduzierender Atmosphäre wie beispielsweise einer Inertgas/Wasserstoff-Atmosphäre zu arbeiten.

Nach Abschluss von Schritt (5') erhält man eine feste Sandwichanordnung aus dem ursprünglich in Schritt (1) bereitgestellten und dem in Schritt (4') bereitgestellten weiteren Bauelement mit dazwischen befindlichem die beiden Bauelemente thermisch leitend, elektrisch leitend und mechanisch verbindendem Lot.

### Erfindungsgemäßes Beispiel 1

Auf die Kupferoberfläche eines DCB-Substrats (Aluminiumoxid-Keramik, 25 mm x 25 mm x 380 µm, beidseitig auf den quadratischen Flächen ausgestattet mit 300 µm Kupfer) wurde mittig eine Lotvorform (Sn3,5Ag; Schmelztemperatur 221 °C; 9 mm x 9 mm x 0,20 mm) aufgelegt und die so geschaffene Anordnung zwischen die beiden auf 150°C vorgeheizten Platten einer Heißpresse (Sinterstar Innovate F-XL der Fa. Boschmann) verbracht. Für einen Zeitraum von 60 Sekunden wurde ein Pressdruck von 100 MPa auf die Probe ausgeübt.

Mittels einer MITUTOYO ABSOLUTE Digimatic Messuhr wurde die Dickenreduktion der Lotvorform ermittelt.

Die Scherfestigkeit der Probe wurde mittels eines DAGE 4000 plus Schertesters der Fa. Nordson bei einer Geschwindigkeit von 0,3 mm/s bei 20°C gemessen.

Ferner wurde die prozentuale Verformung der ursprünglich quadratischen Lotvorform als Änderung der von Scheitelpunkt zu Scheitelpunkt gemessenen Längendimension bestimmt. Eine prozentuale Verformung von <10% repräsentiert ein zufriedenstellendes Ergebnis.

Analog zu Beispiel 1 wurden Beispiele 2 bis 14 durchgeführt. Nachfolgende Tabelle zeigt die Einflüsse von Presstemperatur, Pressdauer bzw. Pressdruck während des Heißpressens.

| Beispiel | Presstemperatur (°C) | Pressdruck (MPa) | Pressdauer (s) | Dickenreduktion (µm) | Verformung (%) | Scherfestigkeit (MPa) |
|---|---|---|---|---|---|---|
| 1 (erf.) | 150 | 100 | 60 | 1 | 0 | >0,1 |
| 2 (erf.) | 150 | 100 | 120 | 2 | 4 | >0,1 |
| 3 (erf.) | 150 | 100 | 300 | 4 | 7 | >0,1 |
| 4 (erf.) | 190 | 100 | 60 | 2 | 5 | >0,1 |
| 5 (erf.) | 190 | 100 | 120 | 7 | 8 | >0,1 |
| 6 (nicht erf.) | 190 | 100 | 300 | 22 | 12 | >0,1 |
| 7 (erf.) | 150 | 50 | 120 | 0 | 0 | >0,1 |
| 8 (nicht erf.) | 150 | 50 | 60 | 0 | 0 | <0,1 |
| 9 (nicht erf.) | 150 | 50 | 10 | 0 | 0 | <0,1 |
| 10 (erf.) | 150 | 50 | 300 | 2 | 4 | >0,1 |
| 11 (erf.) | 190 | 50 | 120 | 4 | 6 | >0,1 |
| 12 (erf.) | 190 | 50 | 60 | 1 | 1 | >0,1 |
| 13 (nicht erf.) | 190 | 50 | 10 | 0 | 0 | <0,1 |
| 14 (erf.) | 190 | 50 | 300 | 6 | 7 | >0,1 |

## Patentansprüche

1. Verfahren zur Herstellung eines mit einer Lotvorform verbundenen Bauelements umfassend die Schritte:
(1) Bereitstellen eines mindestens eine Kontaktfläche aufweisenden Bauelements und einer freien Lotvorform,
(2) Herstellen einer Anordnung aus dem Bauelement und der damit noch nicht verbundenen Lotvorform durch Inkontaktbringen einer oder der einzigen Kontaktfläche des Bauelements mit einer Kontaktfläche der freien Lotvorform, und
(3) Heißpressen der in Schritt (2) hergestellten Anordnung unter Bildung des mit der Lotvorform verbundenen Bauelementes bei einer 10 bis 40% unterhalb der in °C ausgedrückten Schmelztemperatur des Lotmetalls der Lotvorform liegenden Temperatur und einer dabei eine Reduktion der ursprünglichen Dicke der ursprünglich freien Lotvorform von ≤10% bewirkenden Kombination von Pressdruck und Pressdauer.

2. Verfahren nach Anspruch 1, wobei das Bauelement ein Substrat, ein aktives Bauelement oder ein passives Bauelement ist.

3. Verfahren nach Anspruch 1 oder 2, wobei es sich bei der freien Lotvorform um Lotmetallfolie, Lotmetallband oder ein Lotmetallplättchen handelt.

4. Verfahren nach einem der vorhergehenden Ansprüche, wobei die freie Lotvorform 10 bis 500 µm dick ist.

5. Verfahren nach einem der vorhergehenden Ansprüche, wobei die Schmelztemperatur des Lotmetalls der freien Lotvorform im Bereich von 140 bis 380°C liegt.

6. Verfahren nach einem der vorhergehenden Ansprüche, wobei die Schmelztemperatur des Lotmetalls der freien Lotvorform im Bereich von 140 bis 380 °C und die Temperatur während des Heißpressens im Bereich von 84 bis 342 °C liegt.

7. Verfahren nach einem der vorhergehenden Ansprüche, wobei der Pressdruck im Bereich von 10 bis 200 MPa und die Pressdauer im Bereich von 1 Sekunde bis 5 Minuten liegt.

8. Verfahren nach einem der Ansprüche 1 bis 7 umfassend die weiteren Schritte:
(4) Herstellen einer Sandwichanordnung aus mit dem Bauelement verbundener Lotvorform und einem damit zu verbindenden weiteren Bauelement durch Inkontaktbringen der nach außen weisenden Lotmetall-Kontaktfläche der mit dem Bauelement verbundenen Lotvorform mit einer oder der einzigen Kontaktfläche des weiteren Bauelements,
(5) Erhitzen der Sandwichanordnung auf eine Temperatur oberhalb der Schmelztemperatur des Lotmetalls der Lotvorform, und
(6) Abkühlen der Sandwichanordnung unter die Erstarrungstemperatur des zwischen den Bauelementen befindlichen geschmolzenen Lotmetalls unter Ausbildung einer Lötverbindung zwischen den Bauelementen.

9. Verfahren nach einem der Ansprüche 1 bis 7 umfassend die weiteren Schritte:
(4') Herstellen einer Sandwichanordnung aus mit dem Bauelement verbundener Lotvorform und einem damit zu verbindenden weiteren Bauelement durch Inkontaktbringen der nach außen weisenden Lotmetall-Kontaktfläche der mit dem Bauelement verbundenen Lotvorform mit einer oder der einzigen Kontaktfläche des weiteren Bauelements, und
(5') Heißpressen der in Schritt (4') hergestellten Sandwichanordnung bei einer 10 bis 40% unterhalb der in °C ausgedrückten Schmelztemperatur des Lotmetalls der mit dem in Schritt (1) bereitgestellten Bauelement verbundenen Lotvorform liegenden Temperatur unter Ausbildung einer Lotverbindung zwischen den Bauelementen.

10. Verfahren nach Anspruch 9, wobei die während Schritt (5') wirkende Kombination von Pressdruck und Pressdauer in einem Bereich liegt, welcher eine Reduktion der Dicke der verbundenen Lotvorform von ≤10% bewirkt.
